# EUROPÄISCHE PATENTSCHRIFT

(11) **EP 3 457 569 B1**
(45) Veröffentlichungstag und Bekanntmachung des Hinweises auf die Patenterteilung: **29.03.2023**
(21) Anmeldenummer: 18193120.5
(22) Anmeldetag: 07.09.2018
(51) Int. Cl.: H03K 17/955, H03K 17/96

(54) **AUSWERTEANORDNUNG FÜR EINE KAPAZITIVE SENSORVORRICHTUNG**
EVALUATION ARRANGEMENT FOR A CAPACITIVE SENSOR DEVICE
ARRANGEMENT D'ÉVALUATION POUR UN DISPOSITIF DE CAPTEUR CAPACITIF

(30) Priorität: 14.09.2017 DE 102017121377; 04.06.2018 DE 102018113253
(43) Veröffentlichungstag der Anmeldung: 20.03.2019
(73) Patentinhaber: HUF Hülsbeck & Fürst GmbH & Co. KG, 42551 Velbert (DE)
(72) Erfinder: Sieg, Berthold, 46240 Bottrop (DE)
(74) Vertreter: Bals, Rüdiger

(56) Entgegenhaltungen:
- WO-A1-2016/061429
- DE-A1-102012 224 037
- DE-A1-102014 007 236
- DE-U1- 29 721 213
- Meyer Carsten: "Eigene Touch-Sensoren", c't Hardware Hacks 2/2013, 21 May 2013 (2013-05-21), pages 124-131, XP055895167, EAN 4018837000571 Retrieved from the Internet: URL:google search and Heise.de webseite [retrieved on 2022-02-24]

## Beschreibung

Die vorliegende Erfindung betrifft eine Anordnung für eine Auswertung bei einer kapazitiven Sensorvorrichtung eines Fahrzeuges. Ferner bezieht sich die Erfindung auf ein Verfahren für eine Auswertung bei einer kapazitiven Sensorvorrichtung.

Es ist aus dem Stand der Technik bekannt, dass mittels eines Sensorelements wie einer Sensorelektrode eine veränderliche Kapazität gebildet werden kann, welche für Veränderungen in der Umgebung der Sensorelektrode spezifisch ist. In anderen Worten kann durch eine Erfassung der Veränderung dieser Kapazität detektiert werden, wenn eine Annäherung oder eine Geste oder dergleichen im Bereich der Sensorelektrode erfolgt. Diese Detektion wird genutzt, um Funktionen des Fahrzeuges zu aktiveren. Bspw. sind solche Funktionen das Öffnen einer Heckklappe oder das Entriegeln von Fahrzeugtüren.

Da zur Detektion bzw. zur Erfassung der Kapazität elektrische Ladungen verschoben werden, z. B. mittels eines Umladeverfahrens, ist zum einen der Energieverbrauch eines solchen Sensors problematisch, und zum anderen die Störwirkung von elektromagnetischen Feldern als Immission (Störeinwirkung auf den Sensor) und/oder als Emission (Störauswirkung des Sensors auf die Umgebung). Bei derartigen Störwirkungen kann es sich z. B. um externe Störfelder handeln, wie sie bspw. durch ein induktives Aufladen des Fahrzeuges hervorgerufen werden. Eine Verbesserung des Sensors in Bezug auf diese Nachteile ist ggf. technisch aufwendig und/oder kostenaufwendig.

Die DE 10 2012 224 037 A1 offenbart eine Impulsladungsübertragungs-Vorrichtung zur Ladungsübertragung zwischen einem Messkondensator und einem Ladekondensator, die über einen elektronisch bzw. elektrisch steuerbaren elektronischen Umschalter erfolgt, wobei sich ein Entstörkondensator und ein Ankoppelnetzwerk am Eingang des Umschalters befinden.

Die DE102014007236 A1 offenbart eine ähnliche Vorrichtung.

Die WO2016061429 A1 zeigt eine Vorrichtung, bei der die Richtung der Ladungsübertragung jeweils abwechselnd verändert wird.

Es ist daher eine Aufgabe der vorliegenden Erfindung, die voranstehend beschriebenen Nachteile zumindest teilweise zu beheben. Insbesondere ist es Aufgabe der vorliegenden Erfindung, den Energieverbrauch der Auswertung bei einer kapazitiven Sensorvorrichtung eines Fahrzeuges zu verbessern und/oder die Eigenschaften hinsichtlich von Störsignalen zu verbessern.

Die voranstehende Aufgabe wird gelöst durch eine Anordnung mit den Merkmalen des unabhängigen Vorrichtungsanspruchs und durch ein Verfahren mit den Merkmalen des unabhängigen Verfahrensanspruchs. Weitere Merkmale und Details der Erfindung ergeben sich aus den jeweiligen Unteransprüchen, der Beschreibung und den Zeichnungen.

Die Aufgabe wird insbesondere gelöst durch eine Anordnung, vorzugsweise Schaltungsanordnung, für eine Auswertung bei einer kapazitiven Sensorvorrichtung eines Fahrzeuges, insbesondere zur Detektion einer Aktivierungshandlung beim Fahrzeug. Vorteilhaft ist hierbei, wenn das Fahrzeug als ein Kraftfahrzeug, insbesondere als ein Hybridfahrzeug oder als ein Elektrofahrzeug ausgebildet ist, vorzugsweise mit einem Hochvolt-Bordnetz und/oder einem Elektromotor. Außerdem kann es möglich sein, dass das Fahrzeug als ein Brennstoffzellenfahrzeug und/oder Personenkraftfahrzeug und/oder semiautonomes oder autonomes Fahrzeug ausgebildet ist. Vorteilhafterweise weist das Fahrzeug ein Sicherheitssystem auf, welches z. B. durch eine Kommunikation mit einem Identifikationsgeber (ID-Geber) eine Authentifizierung ermöglicht. In Abhängigkeit von der Kommunikation und/oder der Authentifizierung kann wenigstens eine Funktion des Fahrzeuges aktiviert werden. Falls hierzu die Authentifizierung des ID-Gebers notwendig ist, kann es sich bei der Funktion um eine sicherheitsrelevante Funktion handeln, wie ein Entriegeln des Fahrzeuges oder eine Freigabe eines Motorstarts. Somit kann das Sicherheitssystem auch als ein passives Zugangssystem ausgebildet sein, welches ohne aktive manuelle Betätigung des ID-Gebers die Authentifizierung und/oder die Aktivierung der Funktion bei Detektion der Annäherung des ID-Gebers an das Fahrzeug initiiert. Hierzu wird bspw. wiederholt ein Wecksignal durch das Sicherheitssystem ausgesendet, welches durch den ID-Geber bei der Annäherung empfangen werden kann, und dann die Authentifizierung auslöst. Auch kann die Funktion eine Aktivierung einer Fahrzeugbeleuchtung und/oder ein Betätigen (Öffnen und/oder Schließen) einer Klappe (z. B. Front- oder Heck- oder Seitenklappe bzw. -tür) betreffen. Bspw. wird automatisch bei der Detektion der Aktivierungshandlung, wie einer Annäherung oder Geste eines Benutzers, die Funktion aktiviert, z. B. eine Fahrzeugbeleuchtung aktiviert und/oder die Klappe betätigt und/oder die Entriegelung durchgeführt.

Bspw. ist die kapazitive Sensorvorrichtung in einen Türgriff des Fahrzeuges integriert. In diesem Fall kann die Detektion der Aktivierungshandlung, wie eine Annäherung an den Türgriff, z. B. das Entriegeln oder das Öffnen einer Tür bewirken. Auch kann die kapazitive Sensorvorrichtung in einen Stoßfänger oder dergleichen integriert sein. Dann kann die Detektion der Aktivierungshandlung, wie ein Bewegen eines Fußes unterhalb des Stoßfängers, bspw. das Öffnen der Klappe auslösen.

Die erfindungsgemäße Anordnung weist (insbesondere zur Bereitstellung einer Detektion) die Merkmale des Anspruchs 1 auf (Es kann sich bei den nachfolgenden Komponenten vorzugsweise um elektronische Elemente handeln, welche z. B. auf wenigstens einer Leiterplatte angeordnet und/oder elektrisch miteinander verbunden sind.).

In anderen Worten werden für eine (einzige) Ermittlung wiederholte Ladungsübertragungen genutzt, welche im Rahmen dieser (einzigen) Ermittlung den Ladezustand sukzessive verändern, vorzugsweise entweder erhöhen oder verringern. Hierzu ist während und/oder zwischen den Ladungsübertragungen ggf. ein Halten der bereits in der Halteanordnung gespeicherten Ladung notwendig, um das sukzessive Verändern (Erhöhen oder Verringern) des Ladezustands zu ermöglichen. Durch die Ladungsübertragungen kann entsprechend neue Ladung aus dem Sensorelement der Halteanordnung hinzugefügt werden.

Erfindungsgemäß ist die Anzahl der Pulse vorgegeben, d. h. die Anzahl der Ladungsübertragungen für die jeweilige Ermittlung wird vor der Durchführung einer jeweiligen Ermittlung festgelegt und/oder ist vorbekannt und verändert sich somit auch nicht durch die Veränderung der Sensorkapazität. Entsprechend kann hier eine Abgrenzung des genutzten Messprinzips zu herkömmlichen Auswertungen einer Sensorkapazität vorgesehen sein, da nicht die Anzahl der Pulse die (unbekannte) zu erfassende Messgröße ist, sondern stattdessen z. B. der Ladezustand nach der Durchführung der wiederholten Ladungsübertragungen mit der vorgegebenen Anzahl. Bspw. wird hierzu nach der Durchführung der wiederholten Ladungsübertragungen mit der vorgegebenen Anzahl der Ladezustand (insbesondere eine daraus resultierende Spannung) gemessen. Die Höhe des gemessenen Ladezustands und/oder der daraus resultierenden gemessenen Spannung an der Halteanordnung ist dabei bspw. proportional zur Sensorkapazität bzw. zum Parameter. Eine Veränderung des gemessenen Ladezustands für unterschiedliche Ermittlungen lässt dann bspw. auf eine Veränderung in der Umgebung schließen. Das erfindungsgemäße Messprinzip kann dabei die Störanfälligkeit und/oder das Emittieren von Störungen deutlich reduzieren. Außerdem kann durch die Festlegung der Anzahl der wiederholten Ladungsübertragungen eine flexible Anpassung der Auswertefrequenz und/oder des Energieverbrauches erfolgen.

Insbesondere wird die Ladungsübertragung für die jeweilige Ermittlung des Parameters wiederholt durchgeführt, d. h. es werden für eine einzige Ermittlung mehrere Ladungsübertragungen bzw. mehrere Pulse initiiert. In diesem Zusammenhang kann auch von einer Ermittlung mittels mehrerer Pulse gesprochen werden, was z. B. dadurch ermöglicht wird, dass vor jedem der Pulse zunächst das Sensorelement (wieder) aufgeladen und/oder auf ein festes Potential gezogen wird. Anschließend wird durch die Ladungsübertragung die Ladung des Sensorelements auf die Halteanordnung zumindest teilweise oder überwiegend übertragen. Danach kann die Ladung auf der Halteanordnung gespeichert (gehalten) bleiben, z. B. indem die Halteanordnung potentialfrei geschaltet wird, während erneut das Sensorelement für die nächste Ladungsübertragung aufgeladen wird. Dieser Vorgang kann mit der Anzahl N wiederholt werden, d. h. die in der Halteanordnung gespeicherte Ladung akkumuliert werden, bis anschließend zur Auswertung z. B. die Ladeschlussspannung an der Halteanordnung gemessen wird. Anschließend kann ggf. die nächste Ermittlung durchgeführt werden. Durch das wiederholte Durchführen der Ladungsübertragung kann für eine einzelne Ermittlung die Zuverlässigkeit bei der Detektion erhöht werden. Durch das wiederholte Durchführen der Ermittlung (und somit auch der Detektion) kann wiederrum kontinuierlich die Umgebung auf das Vorliegen der Aktivierungshandlung überwacht werden.

Die wiederholte Ermittlung des wenigstens einen für die Erfassung spezifischen Parameters des Sensorelements kann z. B. eine zeitlich wiederholte Bestimmung eines aktuellen Wertes einer veränderlichen Sensorkapazität oder deren Änderung umfassen. Auf diese Weise kann zuverlässig eine Überwachung der Sensorkapazität dahingehend stattfinden, dass eine Veränderung der Sensorkapazität detektiert wird, welche für eine Aktivierungshandlung oder dergleichen spezifisch ist. Die Ermittlung des Parameters und/oder Detektion der Veränderung kann z. B. durch die Messung einer Spannung erfolgen, welche für den Parameter spezifisch ist, bzw. durch die Detektion einer Spannungsdifferenz, welche für die Veränderung der Sensorkapazität bei einer Aktivierungshandlung spezifisch ist. Die Erfassung und/oder Detektion wird vorzugsweise durch eine Verarbeitungsvorrichtung durchgeführt.

Es kann möglich sein, dass für jede oder einige (z. B. jede zweite) der wiederholt durchgeführten Ladungsübertragungen zunächst die Sensorelektrode aufgeladen wird und/oder mit einem festen Potential verbunden wird, um (insbesondere anschließend) eine der Ladungsübertragungen durchzuführen. In anderen Worten kann jede der Ladungsübertragungen zur (zumindest überwiegenden) Entladung des Sensorelements führen, sodass anschließend eine erneute Aufladung des Sensorelements notwendig ist, um erneut die Ladungsübertragung durchführen zu können. Daher ist es ggf. notwendig, dass für die wiederholte Durchführung der Ladungsübertragungen die Haltekapazität größer ist als die Sensorkapazität.

Vorteilhafterweise weist die Halteanordnung einen Haltekondensator auf, welcher eine Haltekapazität als wenigstens ein Vielfaches der Sensorkapazität bereitstellt, wobei letztere durch das Sensorelement gebildet ist. Die Größe der Haltekapazität ist z. B. abhängig von der Anzahl N der Pulse (Wiederholungen der Ladungsübertragungen pro Ermittlung), vorzugsweise proportional hierzu (z. B. ist die Haltekapazität wenigstens N multipliziert mit der Sensorkapazität). Da vorteilhafterweise eine festgelegte und/oder geringe Anzahl N der Pulse genutzt wird, kann ferner der Vorteil erzielt werden, dass die Haltekapazität klein gewählt werden kann, und somit eine Kosten- und/oder Energieersparnis möglich ist.

Es können z. B. die Ladungsübertragungen dadurch durchgeführt werden, dass wiederholte elektrische Pulse mit der vorgegebenen Anzahl zwischen einer Halteanordnung und dem Sensorelement initiiert und/oder übertragen werden. Hierzu kann z. B. das Ansteuerungsmittel, wie wenigstens ein elektrisches Schaltelement und/oder als ein Teil eines Mikrocontrollers genutzt werden, welches mit einem Übertragungspfad zwischen der Halteanordnung und dem Sensorelement verbunden oder darin integriert ist. Ferner kann auch eine Ansteuerungsvorrichtung vorgesehen sein, um die vorgegebene Anzahl der Wiederholungen der Ladungsübertragungen, insbesondere Pulse, festzulegen, sodass diese an eine Haltekapazität der Halteanordnung und/oder an eine Störsignalsensitivität der Auswertung und/oder an einen maximalen Energieverbrauch angepasst sind. Die Ansteuerungsvorrichtung ist hierzu bspw. mit dem wenigstens einen Ansteuerungsmittel bzw. Schaltelement elektrisch verbunden, um dieses entsprechend der Festlegung anzusteuern. Bspw. ist die Ansteuerungsvorrichtung als Mikrocontroller oder als Teil eines Mikrocontrollers ausgebildet, welche die Ansteuerung vornimmt. Auch kann als Ansteuerungsvorrichtung ggf. zumindest ein Teil eines Computerprogramms aufgefasst werden oder ein Computerprogramm als Anpassungsmittel aufweisen, welches bspw. durch einen Mikrocontroller bzw. die Kontrollvorrichtung bzw. die Ansteuerungsvorrichtung ausgeführt wird.

Das durch die erfindungsgemäße Anordnung bereitgestellte Auswerteprinzip kann ggf. auch so verstanden werden, dass nach einer bekannten, vorgegebenen und/oder festen Anzahl von Pulsen (also Ladungsübertragungen) eine Ladeschlussspannung an der Halteanordnung erfasst wird. Die Anzahl und/oder Dauer der Pulse kann dabei festgelegt sein, z. B. durch ein Umschalten wenigstens einer der (bzw. des einzigen) Ansteuerungsmittel(s) für eine bestimmte Schaltdauer, in welcher die Ladungsübertragung ermöglicht wird. Bspw. kann ein Übertragungspfad als Stromzweig zwischen dem Sensorelement und der Halteanordnung für die Schaltdauer durch das (wenigstens eine) Anpassungsmittel geschlossen werden, um während der Schaltdauer die Ladungsübertragung zu ermöglichen und den Puls bereitzustellen. Anders als bei herkömmlichen Umladeverfahren variiert also nicht die Anzahl der Pulse, sondern die Ladeschlussspannung in Abhängigkeit von dem Parameter. Der Parameter ist vorzugsweise eine veränderliche Sensorkapazität des Sensorelements, vorzugsweise einer Sensorelektrode. Auch kann der Parameter eine andere elektrische Eigenschaft des Sensorelements und/oder der Umgebung des Sensorelements betreffen, welche bei einer Veränderung der Umgebung (wie einer Annäherung an das Fahrzeug) sich verändert. Die Bezeichnung des Parameters hängt dabei auch ggf. vom zugrundeliegenden Verständnis des Auswerteprinzips ab. Jedenfalls lässt sich beobachten, dass die Fähigkeit des Sensorelements zur Aufnahme von Ladungsträgern und/oder die bei den Ladungsübertragungen übertragene Ladungsmenge sich bei Einflüssen in der Umgebung verändert. In anderen Worten ändert sich die Ladeschlussspannung, welche (z. B. nach einer Schaltdauer zur Ladungsübertragung) an der Halteanordnung gemessen werden kann. Dieser Parameter kann dann quantitativ ermittelt werden, um die Auswertung durchzuführen und/oder die Aktivierungshandlung zu detektieren.

Es ist dabei vorgesehen, dass das wenigstens eine Ansteuerungsmittel der Kontrollvorrichtung dazu ausgeführt ist, für die jeweilige Ermittlung des Parameters die Ladungsübertragung wiederholt mit der vorgegebenen Anzahl N durchzuführen, sodass sukzessive der Ladezustand der Halteanordnung verändert wird. Die wiederholt durchgeführten Ladungsübertragungen können dabei auch jeweils als Pulse aufgefasst werden, da es bspw. für die jeweilige Ladungsübertragung zu einer impulsartigen elektrischen Ladungsverschiebung kommt. Die wiederholte Durchführung der Ladungsübertragungen, insbesondere Pulse, dient dabei (genau) einer Ermittlung, d. h. jede einzelne Ermittlung erfordert mehrere Ladungsübertragungen bzw. Pulse der Anzahl N. Dies hat den Vorteil, dass gegenüber einer einzelnen Ladungsübertragung pro Ermittlung eine störungsunempfindlichere Ermittlung des Parameters möglich ist.

Ein besonderer Vorteil kann erzielt werden, wenn die Anzahl N der Pulse für jede Ermittlung, d. h. die Anzahl N der Pulse in einer Pulsfolge und/oder die Anzahl N der Ladungsübertragungspulse, klein gewählt wird. Darunter wird insbesondere verstanden, dass die Anzahl N kleiner als 1000 oder kleiner als 200 oder kleiner als 100 ist. Dies hat den Vorteil, dass die Halteanordnung einen Haltekondensator aufweisen kann, welcher nur eine verhältnismäßig geringe Haltekapazität aufweisen kann. Somit können Kosten für die Bauteile, und ggf. auch der Stromverbrauch, reduziert werden.

Es kann vorgesehen sein, dass der Ladezustand der Halteanordnung die Ladungsmenge betrifft, welche durch die Haltekapazität gespeichert wird, und/oder proportional zu einer elektrischen Spannung über der Halteanordnung (insbesondere über wenigstens einen Haltekondensator) ist. Um den Ladezustand zu ermitteln (zu messen), kann somit für jede Ermittlung eine Spannung (Ladeschlussspannung) an der Halteanordnung gemessen werden, z. B. mittels eines Analog-Digital-Wandlers der Kontrollvorrichtung.

Des Weiteren kann vorgesehen sein, dass die Anzahl und/oder eine Pulsdauer der wiederholten Pulse und/oder ein zeitlicher Abstand zwischen den Ermittlungen zur Anpassung an eine Störsignalsensitivität und/oder an einen maximalen Energieverbrauch der Auswertung vorgegeben ist, vorzugsweise um die Störsignalsensitivität für vorgegebene Störfrequenzen und/oder um den Energieverbrauch zu reduzieren. Hierzu kann z. B. die Anzahl der Pulse verringert werden, und/oder durch die Anpassung der Pulse das Frequenzspektrum angepasst werden. Die Nutzung einer geringeren Anzahl von Pulsen wird z. B. durch das erfindungsgemäße Messprinzip ermöglicht. Damit kann eine verbesserte Lösung zur Auswertung bereitgestellt werden.

Des Weiteren ist es im Rahmen der Erfindung der Fall, dass die Anzahl der wiederholten Pulse maximal 500 oder maximal 200 oder maximal 100 beträgt, oder vorzugsweise in einem Bereich von 5 bis 500, bevorzugt 10 bis 350, besonders bevorzugt 20 bis 100 liegt. Dabei bilden die mit der Anzahl N wiederholten Pulse zusammen eine Pulsfolge für die jeweilige Ermittlung des Parameters. Weiter erfolgt für jeden dieser Pulse die Ladungsübertragung, sodass bspw. zwischen dem ersten und letzten Puls der Pulsfolge eine sukzessive Ladungsakkumulation oder Ladungsverringerung bei der Halteanordnung bewirkt wird. Je nach Verschaltung und/oder Richtung der Ladungsverschiebung (der Stromrichtung) kommt es zu einer Akkumulation oder Verringerung. Auch kann ggf. eine Kombination genutzt werden, sodass sowohl Pulse zur Ladungsakkumulation und Pulse zur Ladungsverringerung für eine Ermittlung genutzt werden. Somit kann die Zuverlässigkeit der Auswertung weiter erhöht werden. Ferner kann durch die geringe Anzahl der Pulse außerdem ermöglicht sein, dass die Frequenzsensitivität besonders vorteilhaft verändert wird. Insbesondere liegt dabei eine 3. Harmonische nicht mehr (problematischen) im RF-Bereich (also Funkbereich, RF steht hierbei für Radio Frequency). Somit erfolgt eine zumindest reduzierte Abstrahlung in diesem Bereich und/oder es liegt eine geringere Störsignalempfindlichkeit für Immissionen in diesem Bereich vor.

Nach einer weiteren Möglichkeit kann vorgesehen sein, dass die Anzahl der wiederholten Pulse zur Anpassung an eine Haltekapazität der Halteanordnung vorgegeben ist, wobei vorzugsweise die Haltekapazität größer ist als eine durch das Sensorelement bereitgestellte Sensorkapazität. Hierdurch kann der Ladezustand sich für jeden der Pulse sukzessive einem vollständig geladenen oder entladenen Ladezustand nähern. In gleicher Weise kann auch die Haltekapazität an die Anzahl der Pulse angepasst sein. Dabei kann eine Dimensionierung so erfolgen, dass möglichst eine geringe Anzahl an Wiederholungen durchgeführt wird, um den Energieverbrauch zu reduzieren.

Es ist von Vorteil, wenn im Rahmen der Erfindung die Haltekapazität wenigstens oder genau dem N-fachen einer maximal genutzten Sensorkapazität entspricht, wobei N die Anzahl der wiederholten Pulse für die jeweilige Ermittlung ist. Vorzugsweise ist die maximal genutzte Sensorkapazität die maximal durch das Sensorelement bereitgestellte Kapazität, welche bei der Auswertung als der Parameter ermittelt wird. Auch kann es möglich sein, dass die maximal genutzte Sensorkapazität kleiner als diese bereitgestellte Kapazität ist (es muss nicht zwangsläufig die gesamte Sensorkapazität genutzt werden, dies hängt ggf. von der Konfiguration der Schaltung ab). Damit wird eine zuverlässige Auswertung ermöglicht.

Ferner kann es im Rahmen der Erfindung vorgesehen sein, dass der Parameter eine veränderliche Sensorkapazität ist, welche durch das Sensorelement bereitgestellt ist. Bevorzugt ist eine Verarbeitungseinheit vorgesehen, um anhand des Ladezustands, insbesondere anhand einer Spannung an der Halteanordnung, nach jeder vorgegebenen Anzahl der wiederholten Ladungsübertragungen, also nach jeder Pulsfolge, die Sensorkapazität zu bestimmen. Das Sensorelement kann entsprechend als eine Sensorelektrode ausgebildet sein, welche ggf. in Zusammenwirkung mit einem Massepotential des Fahrzeuges eine Art Kondensator ausbildet. Bspw. kann bei diesem Verständnis des Messprinzips die Umgebung der Sensorelektrode die Kapazität des Kondensators beeinflussen, und somit die veränderliche Sensorkapazität bewirken. Die Verarbeitungseinheit weist bspw. einen Mikrocontroller und/oder einen Analog-Digital-Wandler und/oder dergleichen auf. Bspw. kann ein analoger Spannungswert über wenigstens einen Haltekondensator der Halteanordnung durch den Analog-Digital-Wandler gemessen und in eine digitale Information umgewandelt werden, welche durch die Verarbeitungseinheit ausgewertet wird. Als Ergebnis der Auswertung kann dann z. B. eine Information über die Sensorkapazität bereitgestellt werden.

Ferner kann es möglich sein, dass eine veränderliche Sensorkapazität durch das Sensorelement bereitgestellt ist, welche der zu ermittelnde Parameter ist. Vorzugsweise bilden für die jeweilige Ermittlung der Sensorkapazität die N Pulse eine Pulsfolge zur Ladungsübertragung, um anhand des Ladezustands nach jeder Pulsfolge ein quantitatives Ergebnis über die Sensorkapazität zu erhalten.

Außerdem kann es im Rahmen der Erfindung von Vorteil sein, dass eine Verarbeitungseinheit vorgesehen ist, vorzugsweise ein Analog-Digital-Wandler, um den Ladezustand dadurch zu bestimmen, dass eine elektrische Spannung gemessen wird, welche von der elektrischen Spannung an der Halteanordnung, vorzugsweise eines Haltekondensators, abhängig ist oder dieser entspricht. Damit wird eine zuverlässige Möglichkeit bereitgestellt, um die Auswertung durchzuführen.

Es kann möglich sein, dass die Kontrollvorrichtung wenigstens eine Elektronikkomponente aufweist, und ggf. als ein System aus mehreren Elektronikkomponenten ausgebildet ist. Eine solche Elektronikkomponente ist bspw. die Verarbeitungseinheit und/oder die Halteanordnung und/oder eine Ansteuerungsvorrichtung. Auch ist es denkbar, dass diese Elektronikkomponenten zumindest teilweise als integrierter Schaltkreis vorliegen, und dass z. B. die Ansteuerungsvorrichtung und die Verarbeitungseinheit in einen gemeinsamen integrierten Schaltkreis und/oder Microcontroller oder dergleichen integriert sind. So kann es aus Kostengründen sinnvoll sein, die Verarbeitungseinheit (z. B. einen Analog-Digital-Wandler) als Teil eines Mikrocontrollers zu nutzen. Auch ist es ggf. sinnvoll, die Halteanordnung mit dem Haltekondensator als externes Bauteil zu nutzen, um z. B. eine höhere Haltekapazität bereitstellen zu können.

Es kann ferner vorgesehen sein, dass wenigstens ein Schildelement, wie eine Schildelektrode, vorgesehen ist. Das Schildelement kann in der Umgebung des Sensorelements angeordnet sein, um die Erfassung durch das Sensorelement zu beeinflussen. Hierzu kann das Schildelement auf ein festes elektrisches Potential gelegt werden, wie bspw. ein Massepotential oder ein davon abweichendes festes Potential, z. B. einer Betriebsspannungsquelle. Vorzugsweise wird das Schildelement (bspw. zur Aufladung des Sensorelements oder stets) auf das gleiche Potential gelegt wie das Sensorelement. Hierdurch wird der Vorteil erzielt, dass kein störender Stromfluss aufgrund einer zwischen dem Schildelement und dem Sensorelement ausgebildeten Schildkapazität entsteht, was zu einer verbesserten Erfassung führen kann. Bei einer Ladungsübertragung kann hingegen das Potential des Schildelements verändert werden, um die Ladung des Sensorelements z. B. an eine Halteanordnung zu übertragen. Hierzu wird bspw. das Potential des Schildelements auf das Massepotential gelegt. Das Schildelement ist vorteilhafterweise geometrisch so ausgeführt, dass ein gewünschtes (elektrisches) Überwachungsfeld in der Umgebung des Sensorelements entsteht. Das Überwachungsfeld wird z. B. durch das Sensorelement erzeugt oder bereitgestellt. Bspw. kann das Schildelement das Überwachungsfeld begrenzen, sodass nur in einem nicht vom Schildelement abgeschirmten Bereich die Erfassung der Aktivierungshandlung erfolgt. Auf diese Weise kann mittels des Schildelements bewirkt werden, dass z. B. die Aktivierungshandlung nur aus einer bestimmten Richtung des Sensorelements erfasst wird.

Außerdem kann es optional vorgesehen sein, dass zur Durchführung einer Ladungsübertragung von dem Sensorelement an die Kontrollvorrichtung, z. B. an eine Halteanordnung, ein Potentialwechsel am Sensorelement durchgeführt wird. Hierzu kann das Sensorelement z. B. von einem (von einem Massepotential verschiedenen) festen Potential auf ein Massepotential gelegt werden. Auch kann alternativ oder zusätzlich das Schildelement zur Durchführung der Ladungsübertragung von diesem festen Potential auf das Massepotential gelegt werden. Durch das Schildelement (insbesondere durch den beschriebenen Potentialwechsel z. B. auf das Massepotential) kann ferner ggf. auch der Potentialwechsel beim Sensorelement bewirkt werden. Auch denkbar ist es, dass das Sensorelement stets auf dem festen Potential liegt, z. B. das Potential einer Betriebsspannungsquelle, und nur das elektrische Potential beim Schildelement aktiv gewechselt wird, um hierdurch die Ladungsübertragung vom Sensorelement zu initiieren. Das Schildelement ist hierzu bspw. derart im Erfassungsbereich des Sensorelements angeordnet, dass es Einfluss auf das elektrische Feld des Sensorelements und/oder auf das Potential hat.

Vorzugsweise kann das Schildelement, bevorzugt als Schildelektrode, dadurch eine Veränderung des Überwachungsfeldes des Sensorelements bewirken, dass es räumlich angrenzend zum Überwachungsfeld des Sensorelements angeordnet ist. Das Überwachungsfeld ist z. B. das elektrische Feld, welches durch die Aufladung des Sensorelements hervorgerufen wird und/oder zur Detektion der Aktivierungshandlung dient. Vorzugsweise nur im Überwachungsfeld kann die Veränderung der Umgebung, wie die Aktivierungshandlung, detektiert werden. Ohne ein Schildelement würden allerdings Feldlinien des Überwachungsfeldes ggf. zum niedrigsten Potential in der Umgebung ausgerichtet sein (z. B. zur Fahrzeugtür oder Heckklappe oder Karosserie des Fahrzeuges).

Um dies zu verhindern, kann das Schildelement genutzt werden und insbesondere das gleiche elektrische Potential aufweisen, wie das Sensorelement. Das Feld des Schildelements dient damit als Hindernis für das Überwachungsfeld. Das Schildelement kann dabei bspw. unveränderlich auf einem festen Potential liegen (z. B. stets auf ein Potential einer Betriebsspannungsquelle oder auf ein Massepotential). Auch kann bspw. aktiv das Potential des Schildelements umgeschaltet werden, z. B. auf das gleiche Potential des Sensorelements. Vorteilhafterweise erfolgt die Umschaltung immer dann, wenn auch das Potential des Sensorelements umgeschaltet wird. Dies ist bspw. bei einem Wechsel von einer Aufladung des Sensorelements zu einer Ladungsübertragung aus dem Sensorelement an die Kontrollvorrichtung der Fall (und/oder umgekehrt).

Des Weiteren kann vorgesehen sein, dass eine Ansteuerungsvorrichtung mit dem wenigstens einen Ansteuerungsmittel zur Durchführung von Umschaltvorgängen, z. B. Umschaltungen des Ansteuerungsmittels zwischen einem geschlossenen und geöffneten Zustand, (elektrisch) verschaltet und/oder verbunden ist, derart, dass die Ermittlung des Parameters abwechselnd als eine erste und zweite Ermittlung durchgeführt wird. Bspw. kann das Ansteuerungsmittel als ein elektronischer Schalter ausgeführt sein, welcher durch die Ansteuerungsvorrichtung, wie eine Verarbeitungsvorrichtung und/oder einen Mikrocontroller und/oder dergleichen, angesteuert wird. Die Ansteuerungsvorrichtung kann somit die Umschaltvorgänge und/oder die Ermittlung kontrollieren (also z. B. steuern), und kann daher auch Teil der Kontrollvorrichtung sein und/oder identisch mit der Kontrollvorrichtung sein.

Im Rahmen dieser Erfindung wird unter "elektrisch verbunden" oder auch "elektrisch verschaltet" insbesondere verstanden, dass die elektrische Verbindung bzw. Verschaltung zumindest zeitweise, z. B. auch nur bei einem geschlossenen Zustand eines Schaltelements wie eines elektronischen Schalters, vorliegen kann. Es ist dabei auch denkbar, dass die elektrische Verbindung bzw. Verschaltung nicht ausschließlich elektrisch erfolgt, sondern z. B. auch weitere Mittel zur Signalübertragung zum Einsatz kommen (z. B. eine optische Signalübertragung).

Es ist erfindungsgemäß vorgesehen, dass für die erste Ermittlung die N Ladungsübertragungen eine erste Übertragungsrichtung, vorzugsweise Stromrichtung, aufweisen, und anschließend für die zweite Ermittlung die N Ladungsübertragungen oder mit einer weiteren vorgegebenen Anzahl durchgeführte Ladungsübertragungen eine zweite Übertragungsrichtung (vorzugsweise Stromrichtung) aufweisen, um insbesondere bei der ersten Übertragungsrichtung Ladungen von der Halteanordnung an das Sensorelement und bei der zweiten Übertragungsrichtung Ladungen von dem Sensorelement an die Halteanordnung zu übertragen (oder umgekehrt). Die Umschaltung zwischen der ersten und zweiten Ermittlung und/oder die Durchführung der jeweiligen Ermittlung wird durch die Ansteuerungsvorrichtung gesteuert, z. B. durch ein entsprechendes Schalten von wenigstens einem Ansteuerungsmittel. Insbesondere können dabei mehrere Ansteuerungsmittel in unterschiedliche Schaltzustände gebracht werden, um hierdurch dynamisch Strompfade zu verändern und damit die Stromrichtung zu steuern. Die Nutzung verschiedener Stromrichtungen für die Ladungsübertragung bei wenigstens zwei nachfolgenden Ermittlungen hat den Vorteil, dass Störungen und/oder Fehlerquellen verringert werden, und/oder die Auswertung schneller und/oder zuverlässiger erfolgen kann. Auch ist es optional denkbar, dass das wenigstens eine Ansteuerungsmittel gemäß einer derartigen Sequenz durch eine Ansteuerungsvorrichtung ansteuerbar ist, dass bei den, insbesondere aufeinanderfolgenden, Ermittlungen sich eine Übertragungsrichtung (insbesondere elektrische Stromrichtung) der Ladungsübertragungen unterscheidet, um die Ermittlungen zu kombinieren und so ein störreduziertes Ermittlungsergebnis über den Parameter zu erhalten. Die Kombination kann bspw. nach Durchführung der zwei oder mehr aufeinanderfolgenden Ermittlungen dadurch erfolgen, dass die jeweils hierbei ermittelten Parameter (beide) für eine (einzige) Auswertung ausgewertet und/oder verglichen und/oder addiert werden.

Es ist bei der erfindungsgemäßen Anordnung denkbar, dass mehrere Ermittlungen (also jeweilige Ermittlungsergebnisse, wie ein ermittelter Wert des Parameters) kombiniert werden, z. B. addiert und/oder subtrahiert und/oder gemittelt werden. Auf diese Weise können Störungen und/oder ein Rauschen verringert werden.

Auch ist es denkbar, dass ein Haltekondensator der Halteanordnung für eine einzige Ermittlung mehrfach mit der im Sensorelement gespeicherten Ladung durch die Pulse aufgeladen wird, um eine Störreduzierung und/oder Mittelung zu erzielen. Daher ist es ggf. vorgesehen, dass die elektrische Kapazität des Haltekondensators (die Haltekapazität) wenigstens ein Vielfaches der elektrischen Kapazität der Sensorvorrichtung (der Sensorkapazität, also der durch das Sensorelement gebildeten Kapazität) ist. Es kann sich daher auch um einen Haltekondensator handeln, welcher extern von einem für die Ansteuerungsvorrichtung und/oder für die Verarbeitungseinheit genutzten Mikrocontroller ausgebildet ist. In anderen Worten kann die Nutzung der wiederholten Pulse Störungen und/oder Rauschen reduzieren, da es zu einer Aufsummierung der Ladungen kommt. Erst nach Durchführung der wiederholten Pulse zur Ladungsübertragung kann die Ladeschlussspannung gemessen werden.

Ebenfalls Gegenstand der Erfindung ist ein Verfahren für eine Auswertung bei einer kapazitiven Sensorvorrichtung eines Fahrzeuges, insbesondere zur Detektion einer Aktivierungshandlung beim Fahrzeug. Hierbei ist vorgesehen, dass eine oben beschriebene erfindungsgemäße Anordnung, mit einem Sensorelement und einer Halteanordnung verwendet wird.

Dieses erfindungsgemäße Verfahren ist in Anspruch 7 definiert und bringt die gleichen Vorteile mit sich, wie sie ausführlich mit Bezug auf eine erfindungsgemäße Anordnung beschrieben worden sind.

Erfindungsgemäß unterscheidet sich die erste Ermittlung von der zweiten Ermittlung durch die Übertragungsrichtung (Stromrichtung) der jeweiligen Ladungsübertragungen. Bevorzugt werden die erste Ermittlung und zweite Ermittlung zeitlich wiederholt nacheinander durchgeführt.

Beispielsweise kann es vorgesehen sein, dass (erst) nach jeder der Ermittlungen der Ladezustand mittels einer Ladeschlussspannung erfasst wird, welche von einer elektrischen Spannung der Halteanordnung abhängig ist oder dieser entspricht, und die insbesondere nach jeder Pulsfolge aus Pulsen der vorgegebenen Anzahl an der Halteanordnung anliegt. In anderen Worten kann für jede Ermittlung nach der wiederholten Ladungsübertragung der Ladezustand an der Halteanordnung bestimmt werden, um diesen besonders zuverlässig zur Bestimmung des Parameters zu nutzen. Jede Ermittlung kann also durch die wiederholte Ladungsübertragung bewirkt werden, da die Ladungsübertragungen abhängig von dem Parameter, wie der veränderlichen Kapazität, sind.

Optional kann es vorgesehen sein, dass für eine Erfassung des Ladezustands, vorzugsweise durch eine Messung einer Ladeschlussspannung, das Sensorelement an ein festes Potential, vorzugsweise Massepotential, gelegt wird, und bevorzugt für die erste Ermittlung an ein anderes festes Potential angelegt wird als für die zweite Ermittlung.

Auch ist es z. B. möglich, dass bei der ersten Ermittlung eine Ladungsübertragung von der Halteanordnung, z. B. von einem Haltekondensator, an das Sensorelement erfolgt, und bei der zweiten Ermittlung die Ladungsübertragung umgekehrt erfolgt. Anschließend können ggf. weitere erste und zweite Ermittlungen in der gleichen Reihenfolge durchgeführt werden, um z. B. auf diese Weise Störungen und Fehler bei der Erfassung zu verringern.

Gemäß einem weiteren Vorteil kann vorgesehen sein, dass bei der ersten Ermittlung die Ladungsübertragung von der Halteanordnung zum Sensorelement erfolgt und/oder sowohl die Halteanordnung als auch das Sensorelement aufgeladen werden, und bei der zweiten Ermittlung die Ladungsübertragung von dem Sensorelement zur Halteanordnung erfolgt. Entsprechend können bei nachfolgenden Ermittlungen unterschiedliche Stromrichtungen für die Ladungsübertragung genutzt werden, um Fehler und Störungen bei der Erfassung zu verringern.

Auch ist es optional denkbar, dass die erste Ermittlung und die zweite Ermittlung kombiniert werden, vorzugsweise wenigstens subtrahiert werden, um den Parameter derart zu bestimmen, dass eine Gleichtaktunterdrückung erfolgt. Bspw. kann hierzu für die erste Ermittlung das Sensorelement an ein festes Massepotential gelegt werden, und für die zweite Ermittlung das Sensorelement an ein Potential einer Betriebsspannungsquelle gelegt werden. In anderen Worten kann für die erste Ermittlung (Sample A) eine Entladung des Sensorelements und für die zweite Ermittlung (Sample B) eine Aufladung des Sensorelements genutzt werden, wobei insbesondere die hierdurch hervorgerufene Ladungsverschiebung genutzt wird, um einen Ladezustand bei der Halteanordnung sukzessive zu verändern. Sample A und Sample B, also bspw. die jeweils bei den Ermittlungen erfassten Ladezustände, können dann ggf. subtrahiert werden, um die Gleichtaktunterdrückung zu bewirken. In anderen Worten kann die Kombination dadurch erfolgen, dass ein erstes Ergebnis einer ersten Ermittlung und ein zweites Ergebnis einer zweiten Ermittlung kombiniert werden, um hierdurch ein einziges Gesamtergebnis zu erhalten, mit verbesserter Aussagekraft als die jeweiligen Einzelergebnisse.

In einer weiteren Möglichkeit kann vorgesehen sein, dass die erste Ermittlung und wenigstens eine weitere (zeitlich nachfolgende) erste Ermittlung kombiniert werden, und/oder die zweite Ermittlung und wenigstens eine weitere (zeitlich nachfolgende) zweite Ermittlung kombiniert werden, vorzugsweise wenigstens addiert werden, um den Parameter derart zu bestimmen, dass eine Gegentaktunterdrückung erfolgt. Es können also neben der ersten und zweiten Ermittlung noch weitere erste und zweite Ermittlungen folgen, wobei z. B. gleichartige Ermittlungen (mit gleicher Stromrichtung bei der Ladungsverschiebung) genutzt werden können, um die Gegentaktunterdrückung zu bewirken. In anderen Worten kann ein Sample A mit einem weiteren Sample A und ein Sample B mit einem weiteren Sample B kombiniert werden.

Es ist ferner denkbar, dass die Anzahl N der Pulse fest durch eine Ansteuerungsvorrichtung vorgegeben und/oder unveränderbar für jede Ermittlung ist. Anders als bei herkömmlichen Verfahren handelt es sich dann bei der Anzahl N der Pulse nicht um die Messgröße, sondern es kann stattdessen eine Ladeschlussspannung als Messgröße genutzt werden.

Weiter ist im Rahmen der Erfindung denkbar, dass eine Ansteuerungsvorrichtung dazu ausgeführt ist, eine Pulsdauer der Pulse insbesondere für unterschiedliche Pulsfolgen und/oder unterschiedliche Ermittlungen zu variieren (insbesondere zu modulieren), um eine Frequenzvariation (insbesondere eine Frequenzsensitivität) bei der Auswertung durchzuführen. Bspw. können auch für unterschiedliche Ermittlungen unterschiedliche Frequenzen genutzt werden. Auf diese Weise kann ein gewünschtes Frequenzspektrum erzielt werden, um z. B. Störfrequenzen und/oder eine hohe Empfindlichkeit im Funkbereich zu vermeiden.

Es kann außerdem möglich sein, dass ein Schildelement in Abhängigkeit von der Ladungsübertragung und/oder einer Aufladung des Sensorelements angesteuert wird, vorzugsweise während der Aufladung oder stets auf das gleiche Potential gelegt wird wie das Sensorelement, um einen Überwachungsbereich der Sensorvorrichtung zu definieren. Alternativ oder zusätzlich kann bei der Ladungsübertragung das Schildelement aktiv auf ein festes Potential, wie ein Massepotential und/oder das Potential des Sensorelements, gelegt werden. Auf diese Weise können Störeinflüsse weiter reduziert und/oder gezielt der Überwachungsbereich festgelegt werden, in welchem die Veränderung in der Umgebung bzw. die Aktivierungshandlung durch das Sensorelement erfasst werden kann.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Es zeigen:
Fig. 1 eine schematische Darstellung von Teilen einer erfindungsgemäßen Anordnung,
Fig. 2 ein schematisches Schaltbild einer erfindungsgemäßen Anordnung,
Fig. 3 eine schematische Visualisierung eines erfindungsgemäßen Verfahrens,
Fig. 4 eine weitere schematische Visualisierung eines erfindungsgemäßen Verfahrens,
Fig. 5 ein schematisches Schaltbild einer erfindungsgemäßen Anordnung.

In den nachfolgenden Figuren werden für die gleichen technischen Merkmale auch von unterschiedlichen Ausführungsbeispielen die identischen Bezugszeichen verwendet.

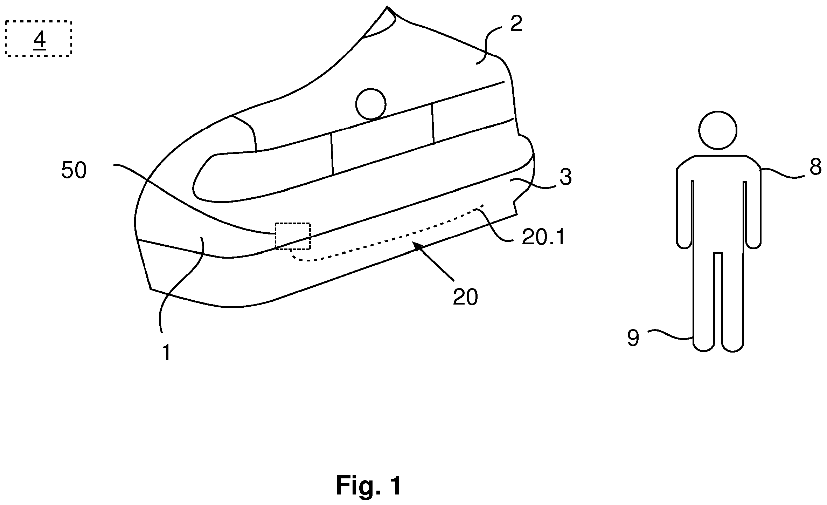

In Figur 1 sind schematisch Teile einer erfindungsgemäßen Anordnung 10 gezeigt, welche beispielhaft im Heckbereich eines Fahrzeug 1 angeordnet ist. Es ist erkennbar, dass wenigstens ein Sensorelement 20.1 einer kapazitiven Sensorvorrichtung 20 einer erfindungsgemäßen Anordnung 10 in einem Stoßfänger 3 des Fahrzeuges 1 angeordnet sein kann. Das Sensorelement 20.1 kann z. B. als Sensorelektrode und/oder als elektrischer Leiter, wie ein elektrisches Kabel, ausgeführt sein. Zur Durchführung eines erfindungsgemäßen Verfahrens kann ferner eine Kontrollvorrichtung 50 am Fahrzeug 1 genutzt werden.

Das Sensorelement 20.1 ist bspw. als langgezogener elektrischer Leiter ausgeführt, welcher sich in Fahrzeugquerrichtung im Stoßfänger 3 erstreckt. Alternativ oder zusätzlich ist eine nicht gezeigte Anordnung des Sensorelements 20.1 im Seiten- oder Frontbereich des Fahrzeuges 1 denkbar, z. B. in einem Türgriff 4 oder dergleichen. Im gezeigten Fall kann das Sensorelement 20.1 genutzt werden, um eine Aktivierungshandlung eines Benutzers 8 zu detektieren. Hierzu bewegt der Benutzer 8 z. B. ein Körperteil 9 als Aktivierungsmittel 9 unterhalb des Stoßfängers 3. Die Detektion dieser Aktivierungshandlung kann sodann zur Aktivierung einer Fahrzeugfunktion, wie einer Öffnung einer Heckklappe 2 führen.

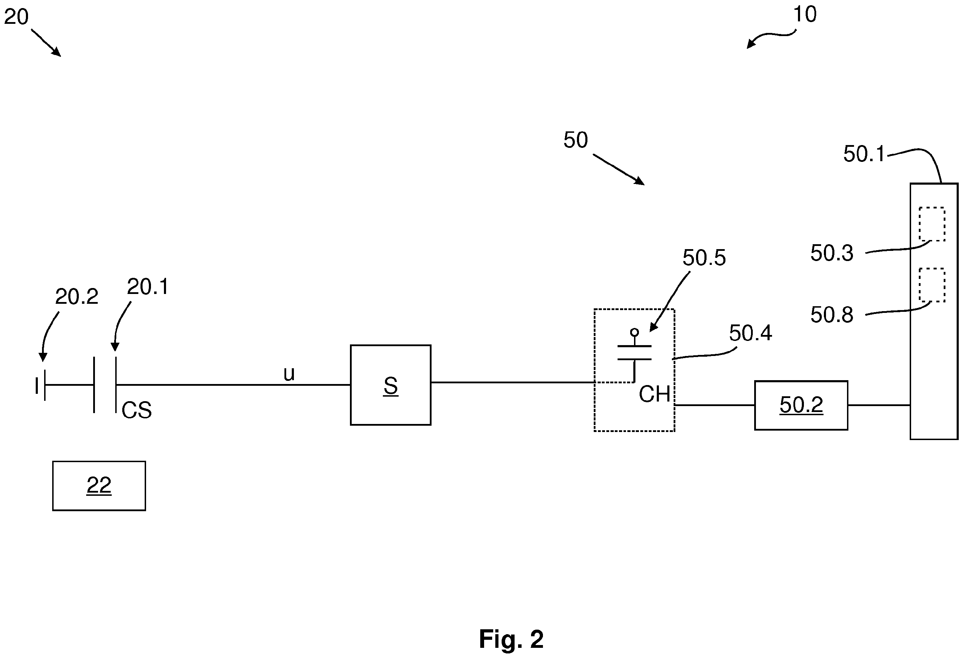

Um die Detektion mit erhöhter Zuverlässigkeit zu ermöglichen, und insbesondere Störeinflüsse und/oder einen Energieverbrauch zu verringern, kann die erfindungsgemäße Anordnung 10 gemäß den Figuren 2, 4 und 5 aufgebaut sein. Die Anordnung 10 dient dabei zur Auswertung bei der Sensorvorrichtung 20 des Fahrzeuges 1, insbesondere zur Detektion der Aktivierungshandlung beim Fahrzeug 1, und nutzt hierzu ggf. die nachfolgenden Elektronikkomponenten:
- wenigstens ein Sensorelement 20.1 zur Erfassung einer Veränderung in einer Umgebung des Sensorelements 20.1, in welcher die Aktivierungshandlung erfolgt,
- eine elektrische Halteanordnung 50.4, welche zur Ladungsübertragung mit dem Sensorelement 20.1 verschaltet und/oder verbunden ist,
- eine Kontrollvorrichtung 50 zur wiederholten Ermittlung wenigstens eines für die Erfassung spezifischen Parameters des Sensorelements 20.1, um die Auswertung durchzuführen, wobei die Halteanordnung 50.4 Teil der Kontrollvorrichtung 50 sein kann, und z. B. auf derselben (nicht dargestellten) Leiterplatte angeordnet sein kann,
- wenigstens ein Ansteuerungsmittel 50.6, insbesondere ein Schaltelement S, der Kontrollvorrichtung 50, um für die jeweilige Ermittlung des Parameters die Ladungsübertragung wiederholt als Pulse P mit einer vorgegebenen Anzahl N durchzuführen, sodass sukzessive ein Ladezustand der Halteanordnung 50.4 verändert wird.

Das Erfassungsprinzip zur Auswertung der Sensorvorrichtung 20 bzw. zur Detektion der Aktivierungshandlung kann so verstanden werden, dass das Sensorelement 20.1, insbesondere als eine Sensorelektrode 20.1, gegenüber einem Massepotential 20.2 eine Sensorkapazität CS ausbildet. Über einen Übertragungspfad u kann daher eine Aufladung der Sensorvorrichtung 20 (d. h. eine Ladungsübertragung zum Sensorelement 20.1) und eine Entladung der Sensorvorrichtung 20 (d. h. eine Ladungsübertragung vom Sensorelement 20.1 bspw. an die Halteanordnung 50.4) erfolgen. Um diese Vorgänge zu steuern, kann z. B. wenigstens ein Schaltelement S als Ansteuerungsmittel 50.6 genutzt werden. Das als Block schematisch in Figur 2 gezeigte Schaltelement S kann dabei repräsentativ für eine Verschaltung mehrerer Schaltelemente S stehen. Bspw. wird das Schaltelement S bzw. das Ansteuerungsmittel 50.6 durch ein Anpassungsmittel 50.3, wie eine Software der Ansteuerungsvorrichtung 50.1, angesteuert. Die Entladung kann dazu führen, dass die Halteanordnung 50.4 mit dem Haltekondensator 50.5 (und der diesem zugeordneten Haltekapazität CH) aufgeladen wird. Wenn der Haltekondensator 50.5 während der Aufladung der Sensorvorrichtung 20 potentialfrei (floating) geschaltet wird, kann zudem die Ladung im Haltekondensator 50.5 erhalten bleiben, bis die nächste Ladungsübertragung vom Sensorelement 20.1 zum Haltekondensator 50.5 zur weiteren Aufladung des Haltekondensators 50.5 erfolgt. Auf diese Weise kann eine Akkumulation der Ladung (und damit eine sukzessive Veränderung des Ladezustands der Halteanordnung 50.4) durchgeführt werden. Nach mehreren Entladungen der Sensorvorrichtung 20 (bzw. Aufladungen des Haltekondensators 50.5) wurde der Ladezustand für jede Entladung sukzessive verändert, und es kann über eine Verarbeitungseinheit 50.2, wie einen Mikrocontroller und/oder Analog-Digital-Wandler, der Ladezustand (also z. B. eine Ladeschlussspannung) erfasst werden. Durch eine Auswertung mittels einer Ansteuerungsvorrichtung 50.1, insbesondere Verarbeitungsvorrichtung 50.1, wie einem Mikrocontroller, kann der Parameter bestimmt werden, und bei Feststellung einer signifikanten Änderung des Parameters auf das Vorliegen der Aktivierungshandlung geschlossen werden. Der Parameter ist bspw. die veränderliche Sensorkapazität CS. Die Verarbeitungseinheit 50.2 kann z. B. auch Teil der Verarbeitungsvorrichtung 50.1 sein.

Außerdem ist in Figur 2 gezeigt, dass wenigstens ein Schildelement 22, wie eine Schildelektrode 22, vorgesehen sein kann. Das Schildelement 22 kann in der Umgebung des Sensorelements 20.1 angeordnet sein, um die Erfassung zu beeinflussen. Hierzu kann das Schildelement 22 auf ein festes elektrisches Potential gelegt werden, wie bspw. ein Massepotential 20.2 oder ein davon abweichendes festes Potential 21, z. B. einer Betriebsspannungsquelle. Vorzugsweise wird das Schildelement 22 auf das gleiche Potential gelegt wie das Sensorelement 20.1. Bei einer Ladungsübertragung kann hingegen ggf. das Potential des Schildelements 22 verändert werden.

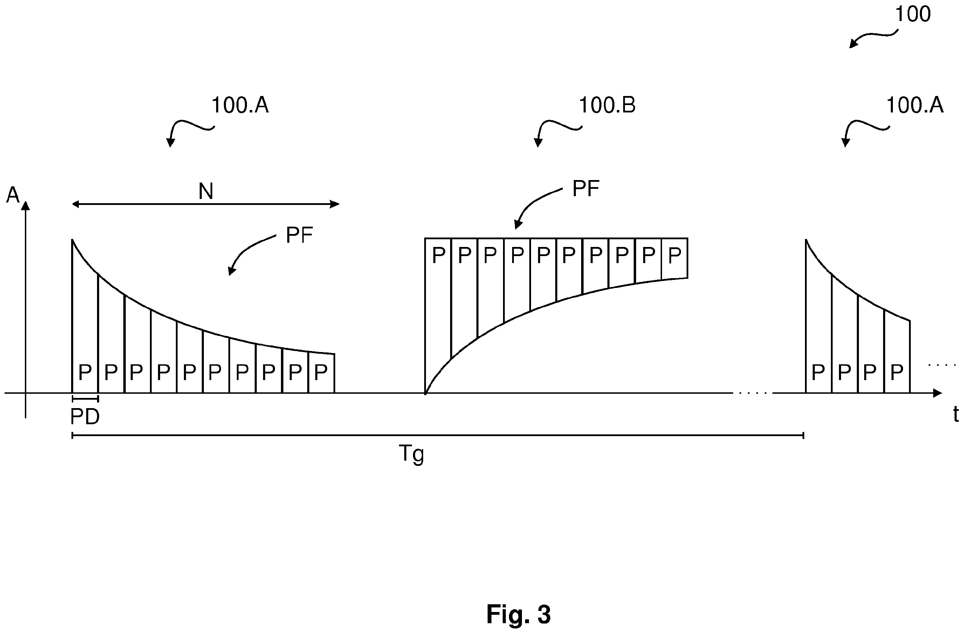

Um eine Ansteuerung dieser Vorgänge gemäß einem erfindungsgemäßen Verfahren zu ermöglichen, wie es z. B. in Figur 3 beispielhaft visualisiert ist, kann der Ablauf der Vorgänge mittels eines Anpassungsmittels 50.3 vorgegeben sein. Es handelt sich hierbei bspw. um eine Software, welche in der Ansteuerungsvorrichtung 50.1 z. B. in einem Datenspeicher 50.8 nicht-flüchtig eingespeichert ist. In Figur 3 ist erkennbar, dass zunächst eine Pulsefolge PF von Pulsen P mit einer ggf. veränderlichen Amplitude A und einer Pulsdauer PD (über die Zeit t) zur Aufladung und/oder Entladung des Sensorelements 20.1 führt. Vorzugsweise erfolgt bei einer ersten Ermittlung 100.A eine Ladungsübertragung von der Halteanordnung 50.4 zum Sensorelement 20.1. Auch kann es bei der ersten Ermittlung 100.A je nach Schaltungskonfiguration möglich sein, dass sowohl die Halteanordnung 50.4 als auch das Sensorelement 20.1 aufgeladen werden. Bei jeder Aufladung kann sich der Ladungszustand der Halteanordnung 50.4 verändert (z. B. erhöhen oder verringern) und die Spannung A über den Haltekondensator 50.5 (je nach Schaltungskonfiguration) erhöhen oder verringern. Beispielhaft gezeigt ist die sukzessive Verringerung der Spannung A bei der ersten Ermittlung 100.A. Der letzte Spannungswert stellt die Ladeschlussspannung dar, welche als Indikator für die Veränderung der Sensorkapazität CS dienen kann. In einer zweiten Ermittlung 100.B kann hingegen eine andere Art der Ladungsübertragung erfolgen, und z. B. die Ladungsübertragung von dem Sensorelement 20.1 zur Halteanordnung 50.4 erfolgen. In diesem Fall ergibt sich eine sukzessive Erhöhung des Ladezustands der Halteanordnung 50.4 bzw. des Haltekondensators 50.5. Die erste und zweite Ermittlung 100.A und 100.B können - wie in Figur 3 zu sehen ist - in dieser Reihenfolge wiederholt durchgeführt werden, wobei ein Abstand Tg zwischen der ersten Ermittlung 100.A und der zeitlich nachfolgenden ersten Ermittlung 100.A vorliegt.

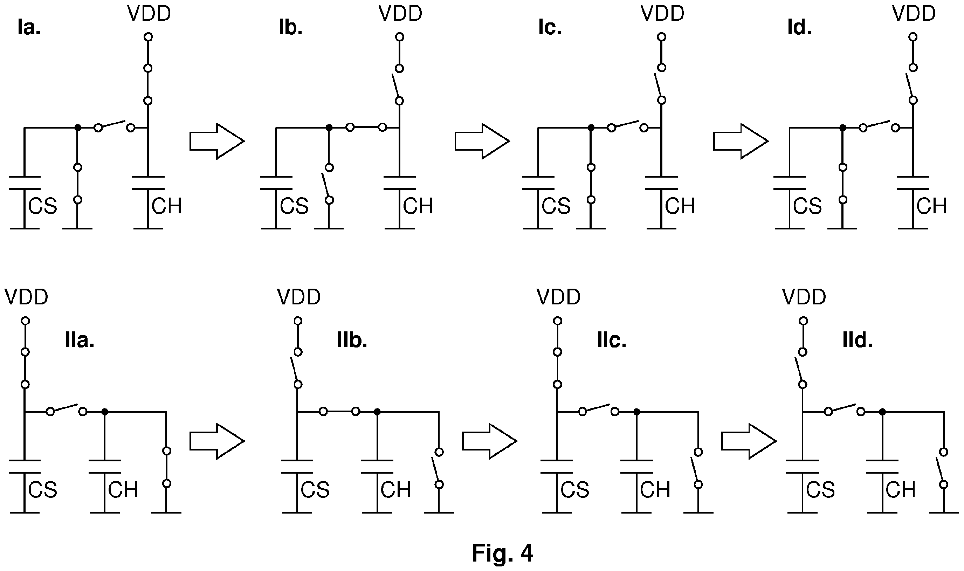

In Figur 4 ist das Prinzip zur Durchführung der Ermittlungen beispielhaft gezeigt, wobei zur vereinfachten Darstellung nur die Kapazitäten CH und CS gezeigt sowie schematische Schalterstellungen von Schaltelementen dargestellt sind. Da es sich um Prinzip-Schaltbilder handelt, kann der tatsächliche Aufbau hiervon abweichen. Gemäß den Verfahrensschritten Ia bis Id erfolgt eine erste Ermittlung 100.A mit einer sukzessiv durchgeführten Ladungsübertragung von der Halteanordnung 50.4 zum Sensorelement 20.1. Gemäß den Verfahrensschritten Ila bis Ild ist die Übertragungsrichtung umgekehrt, nämlich vom Sensorelement 20.1 zur Halteanordnung 50.4.

Zunächst erfolgt gemäß Ia eine Aufladung des Haltekondensator 50.5 der Halteanordnung 50.4 mit der Haltekapazität CH durch eine Energieversorgung VDD (z. B. als ein Potential einer Betriebsspannungsquelle). Anschließend erfolgt gemäß Ib eine Ladungsübertragung von dem Haltekondensator 50.5 an das Sensorelement 20.1, welches eine Sensorkapazität CS bereitstellt. Da die Sensorkapazität CS geringer ist als die Haltekapazität CH, erfolgt hier ggf. keine vollständige Entladung des Haltekondensators 50.5. Als nächstes wird gemäß Ic das Sensorelement 20.1 entladen, indem es mit einem festen Massepotential 20.2 verbunden wird (durch das Umschalten eines entsprechenden Schaltelementes). Die Schritte Ib und Ic werden dann N-fach wiederholt durchgeführt, sodass die Ladungsübertragung wiederholt als Pulse mit einer vorgegebenen Anzahl N durchgeführt wird, um sukzessive einen Ladezustand der Halteanordnung 50.4 zu verändern. Da die Haltekapazität CH wenigstens vielfach größer ist als die Sensorkapazität CS, bewirken ggf. mehrere Wiederholungen eine sukzessive Entladung des Haltekondensator 50.5. In anderen Worten wird die Spannung A über den Haltekondensator 50.5 sukzessive für jede Wiederholung bei jedem Puls verringert (vgl. erste Ermittlung 100.A in Figur 3). Anschließend erfolgt gemäß Schritt Id eine Messung der Spannung (Ladeschlussspannung) über den Haltekondensator 50.5, um einen Wert für den Parameter (insbesondere die Sensorkapazität CS) zu erhalten. Der hierbei gemessene Spannungswert entspricht dem Ermittlungsergebnis der ersten Ermittlung 100.A, also einem ersten Wert des Parameters (Sample A).

Gemäß den Schritten Ila bis Ild erfolgt die umgekehrte Ladungsübertragung von dem Sensorelement 20.1 an den Haltekondensator 50.5. Hierzu wird zunächst gemäß Ila das Sensorelement 20.1 aufgeladen, z. B. durch die Energieversorgung VDD. Gemäß Ilb erfolgt eine Ladungsübertragung von dem Sensorelement 20.1 (am Bezugszeichen CS) zum Haltekondensator 50.5 (am Bezugszeichen CH), da ein entsprechendes Schaltelement einen Strompfad zwischen diesen Elementen 20.1, 50.5 schließt. Gemäß Schritt IIc wird der Haltekondensator 50.5 zumindest an einem Anschluss potentialfrei geschaltet, damit dieser nicht die gespeicherte Ladung verliert. Dann wird das Sensorelement 20.1 erneut aufgeladen. Die Schritte IIb und IIc werden N-fach wiederholt, um sukzessive den Ladungszustand des Haltekondensators 50.5 und damit die Spannung A über den Haltekondensator 50.5 zu erhöhen (vgl. zweite Ermittlung 100.B in Figur 3). Anschließend wird gemäß Ild die Ladeschlussspannung, also die Spannung über den Haltekondensator 50.5 nach Abschluss der wiederholten Ladungsübertragungen für eine jeweilige Ermittlung, gemessen. Der hierbei gemessene Wert entspricht dem Ermittlungsergebnis der zweiten Ermittlung 100.B, also einem zweiten Wert des Parameters (Sample B).

Um die Ermittlung des Parameters zu verbessern, können die Werte Sample A und B miteinander kombiniert werden, z. B. arithmetisch durch eine Verarbeitungsvorrichtung 50.1 addiert und/oder subtrahiert werden. Die Ermittlungen 100.A, 100.B können z. B. alle 8 ms wiederholt werden, um die Detektion einer Aktivierungshandlung durchzuführen. Die Schaltfrequenzen zur Durchführung der Pulse können dabei an potentielle Störfrequenzen angepasst sein. Auch können Signalfilter und/oder eine Signalverarbeitung zum Einsatz kommen, um die Erfassung weiter zu verbessern.

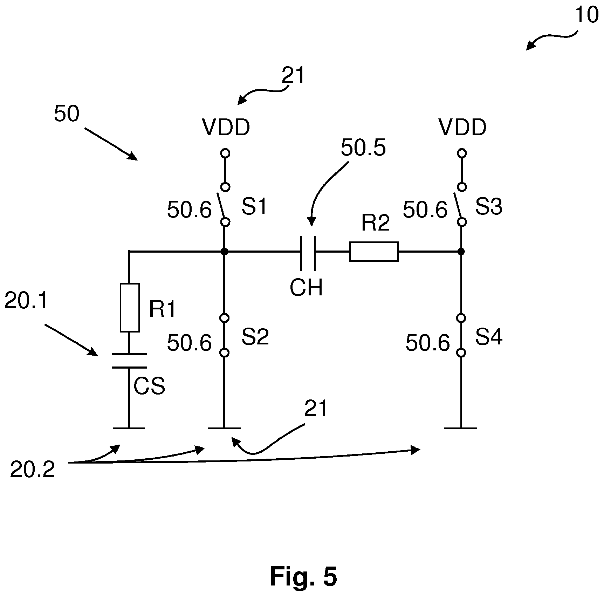

Gemäß Figur 5 ist ein weiteres Prinzip-Schaltbild einer Schaltung gezeigt, welche geeignet ist, die erste und zweite Ermittlung 100.A, 100.B durchzuführen. Neben einer beispielhaften Betriebsspannung VDD sind auch Widerstände R1, R2 dargestellt. Im gezeigten Ausgangszustand sind ein erstes und drittes Schaltelement S1, S3 geöffnet und ein zweites und viertes Schaltelement S2, S4 geschlossen.

Zur Durchführung der ersten Ermittlung 100.A sind dabei zunächst das erste Schaltelement S1 und das dritte Schaltelement S3 geöffnet, ein zweites und viertes Schaltelement S2, S4 hingegen geschlossen. Auf diese Weise werden sowohl das Sensorelement 20.1 als auch der Haltekondensator 50.5 entladen. Anschließend können S1, S2 und S4 geöffnet sowie S3 geschlossen werden, um sowohl das Sensorelement 20.1 (d. h. die hierdurch gebildete Sensorkapazität CS) als auch den Haltekondensator 50.5 zu laden (Ladephase). Anschließend können S1, S3 und S4 geöffnet und S2 geschlossen werden, um auf diese Weise den Haltekondensator 50.5 zumindest an einem Anschluss potentialfrei (floating) zu schalten und den Ladezustand zu erhalten, sowie um das Sensorelement 20.1 zu entladen (Entladephase). Durch die N-fache Wiederholung der Lade- und Entladephase kann der Ladezustand des Haltekondensators 50.5 sukzessive verändert (erhöht) und/oder die Spannung über die Sensorkapazität CS verringert werden. Der nach den Wiederholungen N gemessene Spannungswert (z. B. einer über den Haltekondensator 50.5 gemessenen Ladeschlussspannung) entspricht dabei dem Sample A, und kann bspw. über eine Verarbeitungseinheit 50.2 ermittelt werden.

Zur Ermittlung des Samples B, also der Durchführung der zweiten Ermittlung 100.B, kann zunächst ein erstes Schaltelement S1 und ein drittes Schaltelement S3 geschlossen, ein zweites und viertes Schaltelement S2, S4 geöffnet sein, um die Entladung des Haltekondensators 50.5 und die Aufladung des Sensorelements 20.1 durchzuführen. Dann kann ein Ladungstransfer von dem Sensorelement 20.1 an den Haltekondensator 50.5 erfolgen, indem sämtliche Schaltelemente S1, S2 und S3 mit Ausnahme von S4 geöffnet werden. Danach kann das Sensorelement 20.1 erneut geladen werden, wobei hierzu S1 geschlossen und S2 bis S4 geöffnet werden, um den Ladezustand des Haltekondensators 50.5 zu erhalten. Die letzten beiden Schritte (der Ladungstransfer und die darauffolgende Aufladung des Sensorelements 20.1) werden N-Fach wiederholt, um anschließend durch die Messung der Ladeschlussspannung das Sample B zu ermitteln.

Die voranstehende Erläuterung der Ausführungsformen beschreibt die vorliegende Erfindung ausschließlich im Rahmen von Beispielen.

### Bezugszeichenliste

- 1: Fahrzeug
- 2: Heckklappe
- 3: Stoßfänger
- 4: Türgriff
- 8: Benutzer
- 9: Körperteil, Aktivierungsmittel

- 10: Anordnung, Schaltungsanordnung

- 20: Sensorvorrichtung
- 20.1: Sensorelement, Sensorelektrode
- 20.2: Massepotential
- 21: festes Potential
- 22: Schildelement, Schildelektrode

- 50: Kontrollvorrichtung
- 50.1: Ansteuerungsvorrichtung, Verarbeitungsvorrichtung, Mikrocontroller
- 50.2: Verarbeitungseinheit, Mikrocontroller, Analog-Digital-Wandler
- 50.3: Anpassungsmittel, Software
- 50.4: Halteanordnung
- 50.5: Haltekondensator
- 50.6: Ansteuerungsmittel
- 50.8: Datenspeicher

- 100: Ermittlung
- 100.A: erste Ermittlung
- 100.B: zweite Ermittlung

- t: Zeit
- u: Übertragungspfad
- A: Amplitude, gemessene Spannung
- CH: Haltekapazität
- CS: Sensorkapazität
- N: Anzahl
- P: Puls
- PD: Pulsdauer
- PF: Pulsfolge
- Rn: n-tes Widerstandselement
- S: Schaltelement
- Sn: n-tes Schaltelement
- Tg: Abstand zwischen Messungen (Ermittlungen)

## Patentansprüche

1. Anordnung (10) für eine Auswertung bei einer kapazitiven Sensorvorrichtung (20) eines Fahrzeuges (1), insbesondere zur Detektion einer Aktivierungshandlung beim Fahrzeug (1), aufweisend:
- wenigstens ein Sensorelement (20.1) zur Erfassung einer Veränderung in einer Umgebung des Sensorelements (20.1),
- eine elektrische Halteanordnung (50.4), welche zur Ladungsübertragung mit dem Sensorelement (20.1) verschaltet ist,
- eine Kontrollvorrichtung (50) zur wiederholten Ermittlung (100) wenigstens eines für die Erfassung spezifischen Parameters des Sensorelements (20.1), um die Auswertung durchzuführen,
- wenigstens ein Ansteuerungsmittel (50.6) der Kontrollvorrichtung (50), wobei das wenigstens eine Ansteuerungsmittel (50.6) der Kontrollvorrichtung (50) dazu ausgeführt ist, für die jeweilige Ermittlung (100) des Parameters die Ladungsübertragung wiederholt als Pulse (P) mit einer vorgegebenen Anzahl (N) durchzuführen, sodass sukzessive ein Ladezustand der Halteanordnung (50.4) verändert wird,
wobei die Anzahl (N) der wiederholten Pulse (P) maximal 500 oder maximal 200 oder maximal 100 beträgt, oder vorzugsweise in einem Bereich von 5 bis 500, bevorzugt 10 bis 350, besonders bevorzugt 20 bis 100 liegt, wobei die mit der Anzahl (N) wiederholten Pulse zusammen eine Pulsfolge (PF) für die jeweilige Ermittlung (100) des Parameters bilden, und für jeden dieser Pulse die Ladungsübertragung erfolgt, sodass zwischen dem ersten und letzten Puls der Pulsfolge eine sukzessive Ladungsakkumulation oder - verringerung bei der Halteanordnung (50.4) erfolgt,
wobei eine Ansteuerungsvorrichtung (50.1) mit dem wenigstens einen Ansteuerungsmittel (50.6) zur Durchführung von Umschaltvorgängen verschaltet ist, derart, dass die Ermittlung (100) des Parameters abwechselnd als eine erste und zweite Ermittlung (100.A, 100.B) durchgeführt wird, wobei
- für die erste Ermittlung (100.A) die N Ladungsübertragungen eine erste Übertragungsrichtung, vorzugsweise Stromrichtung, aufweisen,
- anschließend für die zweite Ermittlung (100.B) die N Ladungsübertragungen oder mit einer weiteren vorgegebenen Anzahl durchgeführte Ladungsübertragungen eine zweite Übertragungsrichtung aufweisen,
um bei der ersten Übertragungsrichtung Ladungen von der Halteanordnung (50.4) an das Sensorelement (20.1) und bei der zweiten Übertragungsrichtung Ladungen von dem Sensorelement (20.1) an die Halteanordnung (50.4) zu übertragen.

2. Anordnung (10) nach Anspruch 1,
**dadurch gekennzeichnet,**
**dass** die Anzahl (N) und/oder eine Pulsdauer (PD) der wiederholten Pulse (P) und/oder ein zeitlicher Abstand (Tg) zwischen den Ermittlungen (100) zur Anpassung an eine Störsignalsensitivität der Auswertung vorgegeben ist, um die Störsignalsensitivität für vorgegebene Störfrequenzen zu reduzieren.

3. Anordnung (10) nach Anspruch 1 oder 2,
**dadurch gekennzeichnet,**
**dass** die Anzahl (N) der wiederholten Pulse (P) zur Anpassung an eine Haltekapazität (CH) der Halteanordnung (50.4) vorgegeben ist, wobei die Haltekapazität (CH) größer ist als eine durch das Sensorelement (20.1) bereitgestellte Sensorkapazität (CS), sodass der Ladezustand sich für jeden Puls (P) sukzessive einem vollständig geladenen oder entladenen Ladezustand nähert.

4. Anordnung (10) nach einem der vorhergehenden Ansprüche,
**dadurch gekennzeichnet,**
**dass** die Haltekapazität (CH) wenigstens oder genau dem N-fachen einer maximal genutzten Sensorkapazität (CS) entspricht, wobei N die Anzahl (N) der wiederholten Pulse (P) für die jeweilige Ermittlung (100) ist, und vorzugsweise die maximal genutzte Sensorkapazität (CS) die maximal durch das Sensorelement (20.1) bereitgestellte Kapazität ist, welche bei der Auswertung als der Parameter ermittelt wird.

5. Anordnung (10) nach einem der vorhergehenden Ansprüche,
**dadurch gekennzeichnet,**
**dass** der Parameter eine veränderliche Sensorkapazität (CS) ist, welche durch das Sensorelement (20.1) bereitgestellt ist, und
eine Verarbeitungseinheit (50.2) vorgesehen ist, um anhand des Ladezustands nach jeder vorgegebenen Anzahl (N) der wiederholten Ladungsübertragungen, also nach jeder Pulsfolge (PF), die Sensorkapazität (CS) zu bestimmen
und/oder dass eine Verarbeitungseinheit (50.2) vorgesehen ist, vorzugsweise ein Analog-Digital-Wandler (50.2), um den Ladezustand dadurch zu bestimmen, dass eine elektrische Spannung gemessen wird, welche von der elektrischen Spannung an der Halteanordnung (50.4), vorzugsweise eines Haltekondensators (50.5), abhängig ist oder dieser entspricht.

6. Anordnung (10) nach einem der vorhergehenden Ansprüche,
**dadurch gekennzeichnet,**
**dass** das wenigstens eine Ansteuerungsmittel (50.6) gemäß einer derartigen Sequenz durch eine Ansteuerungsvorrichtung (50.1) ansteuerbar ist, dass bei den, insbesondere aufeinanderfolgenden, Ermittlungen (100) sich eine Übertragungsrichtung der Ladungsübertragungen unterscheidet, um die Ermittlungen (100) zu kombinieren und so ein störreduziertes Ermittlungsergebnis über den Parameter zu erhalten.

7. Verfahren für eine Auswertung bei einer kapazitiven Sensorvorrichtung (20) eines Fahrzeuges (1), insbesondere zur Detektion einer Aktivierungshandlung beim Fahrzeug (1), wobei eine Anordnung (10) aufweisend ein Sensorelement (20.1) und eine Halteanordnung (50.4) vorgesehen ist, wobei die Anordnung (10) nach einem der Ansprüche 1 bis 6 ausgebildet ist,
**wobei die nachfolgenden Schritte durchgeführt werden:**
a) Durchführen wenigstens einer ersten Ermittlung (100.A) eines Parameters des Sensorelements (20.1),
b) Durchführen wenigstens einer zweiten Ermittlung (100.B) des Parameters,
wobei für die jeweilige Ermittlung (100) des Parameters eine Ladungsübertragung zwischen dem Sensorelement (20.1) und der Halteanordnung (50.4) wiederholt als Pulse (P) mit einer vorgegebenen Anzahl (N) durchgeführt wird, sodass sukzessive ein Ladezustand der Halteanordnung (50.4) verändert wird, um anhand des Ladezustands den Parameter zu bestimmen.

8. Verfahren nach Anspruch 7,
**dadurch gekennzeichnet,**
**dass** nach jeder Ermittlung (100) der Ladezustand mittels einer Ladeschlussspannung erfasst wird, welche von einer elektrischen Spannung der Halteanordnung (50.4) abhängig ist oder dieser entspricht, die nach einer jeden Pulsfolge (PF) aus Pulsen (P) der vorgegebenen Anzahl (N) an der Halteanordnung (50.4) anliegt.

9. Verfahren nach einem der Ansprüche 7-8,
**dadurch gekennzeichnet,**
**dass** für eine Erfassung des Ladezustands, vorzugsweise durch eine Messung einer Ladeschlussspannung, das Sensorelement (20.1) an ein festes Potential (21), vorzugsweise Massepotential (20.2), gelegt wird, und bevorzugt für die erste Ermittlung (100.A) an ein anderes festes Potential (21) angelegt wird als für die zweite Ermittlung (100.B).

10. Verfahren nach einem der Ansprüche 7-9,
**dadurch gekennzeichnet,**
**dass** bei der ersten Ermittlung (100.A) die Ladungsübertragung von der Halteanordnung (50.4) zum Sensorelement (20.1) erfolgt und/oder sowohl die Halteanordnung (50.4) als auch das Sensorelement (20.1) aufgeladen werden, und bei der zweiten Ermittlung (100.B) die Ladungsübertragung von dem Sensorelement (20.1) zur Halteanordnung (50.4) erfolgt
und/oder dass die erste Ermittlung (100.A) und die zweite Ermittlung (100.B) kombiniert werden, vorzugsweise wenigstens subtrahiert werden, um den Parameter derart zu bestimmen, dass eine Gleichtaktunterdrückung erfolgt
und/oder dass die erste Ermittlung (100.A) und wenigstens eine weitere erste Ermittlung (100.A) kombiniert werden, und/oder die zweite Ermittlung (100.B) und wenigstens eine weitere zweite Ermittlung (100.B) kombiniert werden, vorzugsweise wenigstens addiert werden, um den Parameter derart zu bestimmen, dass eine Gegentaktunterdrückung erfolgt.

11. Verfahren nach einem der Ansprüche 7-10,
**dadurch gekennzeichnet,**
**dass** die Anzahl der Pulse (P) fest durch eine Ansteuerungsvorrichtung (50.1) vorgegeben und/oder unveränderbar für jede Ermittlung (100) ist.

12. Verfahren nach einem der Ansprüche 7-11,
**dadurch gekennzeichnet,**
**dass** eine Ansteuerungsvorrichtung (50.1) dazu ausgeführt ist, eine Pulsdauer (PD) der Pulse (P), insbesondere für unterschiedliche Pulsfolgen (PF), und/oder unterschiedliche Ermittlungen (100) zu variieren, um eine Frequenzvariation bei der Auswertung durchzuführen.

13. Verfahren nach einem der Ansprüche 7-12,
**dadurch gekennzeichnet,**
**dass** ein Schildelement (22) in Abhängigkeit von der Ladungsübertragung und/oder einer Aufladung des Sensorelements (20.1) angesteuert wird, und vorzugsweise während der Aufladung auf das gleiche Potential gelegt wird wie das Sensorelement (20.1), um einen Überwachungsbereich der Sensorvorrichtung (20) zu definieren.

## Claims

1. Arrangement (10) for an evaluation at a capacitive sensor device (20) of a vehicle (1), in particular for the detection of an activation action at the vehicle (1), comprising:
- at least one sensor element (20.1) for detecting a change in an environment of the sensor element (20.1),
- an electrical holding arrangement (50.4), which is connected to the sensor element (20.1) for charge transfer,
- a control device (50) for repeatedly determining (100) at least one parameter of the sensor element (20.1) specific to the detection in order to perform the evaluation,
- at least one drive means (50.6) of the control device (50), the at least one drive means (50.6) of the control device (50) being designed to carry out the charge transfer repeatedly as pulses (P) with a predetermined number (N) for the respective determination (100) of the parameter, so that a charge state of the holding arrangement (50.4) is successively changed,
wherein the number (N) of repeated pulses (P) is at most 500 or at most 200 or at most 100, or preferably lies in a range of 5 to 500, preferably 10 to 350, particularly preferably 20 to 100, wherein the pulses repeated with the number (N) together form a pulse sequence (PF) for the respective determination (100) of the parameter, and for each of these pulses the charge transfer takes place so that between the first and last pulse of the pulse sequence a successive charge accumulation or reduction takes place in the holding arrangement (50.4),
wherein a drive device (50.1) is connected to the at least one drive means (50.6) for performing switching operations, such that the determination (100) of the parameter is performed alternately as a first and second determination (100.A, 100.B), wherein
- for the first determination (100.A) the N charge transfers have a first transfer direction, preferably current direction,
- subsequently, for the second determination (100.B), the N charge transfers or charge transfers carried out with a further predetermined number have a second transfer direction,
to transfer charges from the holding arrangement (50.4) to the sensor element (20.1) in the first transfer direction and to transfer charges from the sensor element (20.1) to the holding arrangement (50.4) in the second transfer direction.

2. Arrangement (10) according to claim 1,
**characterized in that**
the number (N) and/or a pulse duration (PD) of the repeated pulses (P) and/or a time interval (Tg) between the determinations (100) is predetermined for adaptation to a disturbance signal sensitivity of the evaluation in order to reduce the disturbance signal sensitivity for predetermined disturbance frequencies.

3. Arrangement (10) according to claim 1 or 2,
**characterized in that**
the number (N) of repeated pulses (P) is predetermined for adaptation to a holding capacitance (CH) of the holding arrangement (50.4), the holding capacitance (CH) being greater than a sensor capacitance (CS) provided by the sensor element (20.1), so that the charge state successively approaches a fully charged or discharged charge state for each pulse (P).

4. Arrangement (10) according to any one of the preceding claims,
**characterized in that**
the holding capacitance (CH) corresponds at least or exactly to N times a maximum utilized sensor capacitance (CS), where N is the number (N) of repeated pulses (P) for the respective determination (100), and preferably the maximum utilized sensor capacitance (CS) is the maximum capacitance provided by the sensor element (20.1) which is determined as the parameter during the evaluation.

5. Arrangement (10) according to any one of the preceding claims,
**characterized in that**
the parameters is a variable sensor capacitance (CS) provided by the sensor element (20.1), and
a processing unit (50.2) is provided for determining the sensor capacitance (CS) on the basis of the state of charge after each predetermined number (N) of repeated charge transfers, i.e. after each pulse sequence (PF)
and/or **in that** a processing unit (50.2) is provided, preferably an analog-to-digital converter (50.2), for determining the state of charge by measuring an electrical voltage which is dependent on or corresponds to the electrical voltage at the holding arrangement (50.4), preferably a holding capacitor (50.5).

6. Arrangement (10) according to any one of the preceding claims,
**characterized in that**
the at least one drive means (50.6) can be driven by a drive device (50.1) in accordance with a sequence such that, in the case of the, in particular successive, determinations (100), a transmission direction of the charge transmissions differs in order to combine the determinations (100) and thus to obtain an interference-reduced determination result via the parameter.

7. Method for an evaluation in a capacitive sensor device (20) of a vehicle (1), in particular for detecting an activation action in the vehicle (1), wherein an arrangement (10) comprising a sensor element (20.1) and a holding arrangement (50.4) is provided, wherein the arrangement (10) is designed according to one of claims 1 to 6,
**whereby the following steps are carried out:**
a) performing at least a first determination (100.A) of a parameter of the sensor element (20.1),
b) performing at least a second determination (100.8) of the parameter,
wherein for the respective determination (100) of the parameter a charge transfer between the sensor element (20.1) and the holding arrangement (50.4) is repeatedly carried out as pulses (P) with a predetermined number (N), so that successively a state of charge of the holding arrangement (50.4) is changed in order to determine the parameter on the basis of the state of charge.

8. The method according to claim 7,
**characterized in that**
after each determination (100), the state of charge is detected by means of a charge termination voltage which is dependent on or corresponds to an electrical voltage of the holding arrangement (50.4) which is applied to the holding arrangement (50.4) after each pulse sequence (PF) of pulses (P) of the predetermined number (N).

9. The method according to any one of claims 7 or 8,
**characterized in that**
for a detection of the state of charge, preferably by a measurement of a charging termination voltage, the sensor element (20.1) is applied to a fixed potential (21), preferably ground potential (20.2), and preferably for the first detection (100.A) is applied to a different fixed potential (21) than for the second detection (100.B).

10. The method according to any one of claims 7 to 9,
**characterized in that**
during the first determination (100.A) the charge transfer from the holding arrangement (50.4) to the sensor element (20.1) takes place and/or both the holding arrangement (50.4) and the sensor element (20.1) are charged, and during the second determination (100.B) the charge transfer from the sensor element (20.1) to the holding arrangement (50.4) takes place
and/or **in that** the first determination (100.A) and the second determination (100.B) are combined, preferably at least subtracted, in order to determine the parameter in such a way that common-mode suppression is performed
and/or **in that** the first determination (100.A) and at least one further first determination (100.A) are combined, and/or the second determination (100.B) and at least one further second determination (100.B) are combined, preferably at least added, in order to determine the parameter in such a way that push-pull suppression takes place.

11. The method according to any one of claims 7 to 10,
**characterized in that**
the number of pulses (P) is fixedly predetermined by a drive device (50.1) and/or is invariable for each determination (100).

12. The method according to any one of claims 7 to 11,
**characterized in that**
a drive device (50.1) is designed to vary a pulse duration (PD) of the pulses (P), in particular for different pulse sequences (PF), and/or different determinations (100), in order to carry out a frequency variation during the evaluation.

13. The method according to any one of claims 7 to 12,
**characterized in that**
a shield element (22) is triggered in dependence on the charge transfer and/or a charging of the sensor element (20.1), and is preferably applied to the same potential as the sensor element (20.1) during the charging in order to define a monitoring area of the sensor device (20).

## Revendications

1. Dispositif (10) pour une évaluation dans un dispositif de détection capacitif (20) d'un véhicule (1), présentant en particulier pour la détection d'une action d'activation dans le véhicule (1) :
- au moins un élément de détection (20.1) pour détecter une modification dans un environnement de l'élément de détection (20.1),
- un dispositif de maintien électrique (50.4) qui est connecté à l'élément de détection (20.1) pour le transfert de charge,
- un dispositif de contrôle (50) pour la détermination répétée (100) d'au moins un paramètre de l'élément de détection (20.1) spécifique à la détection, afin d'effectuer l'évaluation,
- au moins un moyen de commande (50.6) du dispositif de contrôle (50), l'au moins un moyen de commande (50.6) du dispositif de contrôle (50) étant conçu pour effectuer de manière répétée le transfert de charge sous forme d'impulsions (P) avec un nombre prédéterminé (N) pour la détermination respective (100) du paramètre, de sorte qu'un état de charge du dispositif de maintien (50.4) est modifié successivement,
le nombre (N) d'impulsions (P) répétées étant au maximum de 500 ou au maximum de 200 ou au maximum de 100, ou se situant de préférence dans une plage de 5 à 500, de préférence de 10 à 350, de manière particulièrement préférée de 20 à 100, les impulsions répétées avec le nombre (N) formant ensemble une séquence d'impulsions (PF) pour la détermination (100) respective du paramètre, et le transfert de charge s'effectuant pour chacune de ces impulsions, de sorte qu'entre la première et la dernière impulsion de la séquence d'impulsions, il se produit une accumulation ou une diminution successive de charge dans le dispositif de maintien (50.4),
un dispositif de commande (50.1) étant connecté à l'au moins un moyen de commande (50.6) pour effectuer des opérations de commutation, de telle sorte que la détermination (100) du paramètre est effectuée en alternance comme une première et une deuxième détermination (100.A, 100.B), où
- pour la première détermination (100.A), les N transferts de charge présentent une première direction de transfert, de préférence une direction de courant,
- ensuite, pour la deuxième détermination (100.B), les N transferts de charge ou les transferts de charge effectués avec un autre nombre prédéterminé présentent une deuxième direction de transfert,
pour transférer des charges du dispositif de maintien (50.4) à l'élément de détection (20.1) dans le premier sens de transfert et des charges de l'élément de détection (20.1) au dispositif de maintien (50.4) dans le deuxième sens de transfert.

2. Dispositif (10) selon la revendication 1,
**caractérisé en ce que**
le nombre (N) et/ou une durée d'impulsion (PD) des impulsions (P) répétées et/ou un intervalle de temps (Tg) entre les déterminations (100) sont prédéfinis pour l'adaptation à une sensibilité aux signaux parasites de l'évaluation, afin de réduire la sensibilité aux signaux parasites pour des fréquences parasites prédéfinies.

3. Dispositif (10) selon la revendication 1 ou 2,
**caractérisé en ce que**
le nombre (N) des impulsions (P) répétées est prédéfini pour l'adaptation à une capacité de maintien (CH) du dispositif de maintien (50.4), la capacité de maintien (CH) étant supérieure à une capacité de capteur (CS) fournie par l'élément de détection (20.1), de sorte que l'état de charge se rapproche successivement d'un état de charge complètement chargé ou déchargé pour chaque impulsion (P).

4. Dispositif (10) selon l'une quelconque des revendications précédentes,
**caractérisé en ce que**
la capacité de maintien (CH) correspond au moins ou exactement à N fois une capacité de capteur (CS) utilisée au maximum, N étant le nombre (N) des impulsions (P) répétées pour la détermination (100) respective, et de préférence la capacité de capteur (CS) utilisée au maximum est la capacité maximale mise à disposition par l'élément de détection (20.1), qui est déterminée comme le paramètre lors de l'évaluation.

5. Dispositif (10) selon l'une quelconque des revendications précédentes,
**caractérisé en ce que**
le paramètre est une capacité de capteur variable (CS), qui est fournie par l'élément de détection (20.1), et
une unité de traitement (50.2) est prévue pour déterminer la capacité du capteur (CS) à l'aide de l'état de charge après chaque nombre prédéterminé (N) de transferts de charge répétés, donc après chaque séquence d'impulsions (PF)
et/ou **en ce qu'**il est prévu une unité de traitement (50.2), de préférence un convertisseur analogique-numérique (50.2), pour déterminer l'état de charge en mesurant une tension électrique qui dépend de la tension électrique aux bornes du dispositif de maintien (50.4), de préférence d'un condensateur de maintien (50.5), ou qui correspond à celle-ci.

6. Dispositif (10) selon l'une quelconque des revendications précédentes,
**caractérisé en ce que**
le au moins un moyen de commande (50.6) peut être commandé par un dispositif de commande (50.1) selon une séquence telle que, lors des déterminations (100), en particulier successives, une direction de transfert des transferts de charge se différencie pour combiner les déterminations (100) et obtenir ainsi un résultat de détermination à perturbation réduite sur le paramètre.

7. Procédé pour une évaluation dans un dispositif de détection capacitif (20) d'un véhicule (1), en particulier pour la détection d'une action d'activation dans le véhicule (1), dans lequel est prévu un dispositif (10) présentant un élément de détection (20.1) et un agencement de maintien (50.4), l'agencement (10) étant réalisé selon l'une des revendications 1 à 6,
**en effectuant les étapes suivantes :**
a) effectuer au moins une première détermination (100.A) d'un paramètre de l'élément de détection (20.1),
b) effectuer au moins une deuxième détermination (100.B) du paramètre,
un transfert de charge entre l'élément de détection (20.1) et le dispositif de maintien (50.4) étant effectué de manière répétée sous forme d'impulsions (P) avec un nombre (N) prédéfini pour la détermination (100) respective du paramètre, de sorte qu'un état de charge du dispositif de maintien (50.4) est modifié successivement afin de déterminer le paramètre à l'aide de l'état de charge.

8. Procédé selon la revendication 7,
**caractérisé en ce que**
après chaque détermination (100), l'état de charge est détecté au moyen d'une tension de fin de charge qui dépend d'une tension électrique du dispositif de maintien (50.4) ou qui correspond à celle-ci, qui est appliquée au dispositif de maintien (50.4) après chaque séquence d'impulsions (PF) constituée d'impulsions (P) du nombre prédéterminé (N).

9. Procédé selon l'une des revendications 7 ou 8,
**caractérisé en ce que**
pour une détection de l'état de charge, de préférence par une mesure d'une tension de fin de charge, l'élément de détection (20.1) est appliqué à un potentiel fixe (21), de préférence un potentiel de masse (20.2), et de préférence pour la première détermination (100.A) est appliqué à un autre potentiel fixe (21) que pour la deuxième détermination (100.B).

10. Procédé selon l'une quelconque des revendications 7 à 9,
**caractérisé en ce que**
lors de la première détermination (100.A), le transfert de charge s'effectue du dispositif de maintien (50.4) à l'élément de détection (20.1) et/ou aussi bien le dispositif de maintien (50.4) que l'élément de détection (20.1) sont chargés, et lors de la deuxième détermination (100.B), le transfert de charge s'effectue de l'élément de détection (20.1) au dispositif de maintien (50.4)
et/ou **en ce que** la première détermination (100.A) et la deuxième détermination (100.B) sont combinées, de préférence au moins soustraites, pour déterminer le paramètre de telle sorte qu'une suppression de mode commun ait lieu
et/ou **en ce que** la première détermination (100.A) et au moins une autre première détermination (100.A) sont combinées, et/ou la deuxième détermination (100.B) et au moins une autre deuxième détermination (100.B) sont combinées, de préférence au moins additionnées, pour déterminer le paramètre de telle sorte qu'il se produise une suppression de push-pull.

11. Procédé selon l'une quelconque des revendications 7 à 10,
**caractérisé en ce que**
le nombre des impulsions (P) est prédéfini de manière fixe par un dispositif de commande (50.1) et/ou est invariable pour chaque détermination (100).

12. Procédé selon l'une quelconque des revendications 7 à 11,
**caractérisé en ce que**
un dispositif de commande (50.1) est réalisé pour faire varier une durée d'impulsion (PD) des impulsions (P), en particulier pour différentes séquences d'impulsions (PF), et/ou différentes déterminations (100), afin d'effectuer une variation de fréquence lors de l'évaluation.

13. Procédé selon l'une quelconque des revendications 7 à 12,
**caractérisé en ce qu'**
un élément de protection (22) est commandé en fonction du transfert de charge et/ou d'une charge de l'élément de détection (20.1), et est de préférence placé au même potentiel que l'élément de détection (20.1) pendant la charge, afin de définir une zone de surveillance du dispositif de détection (20).
